# DEMANDE DE BREVET EUROPEEN

(11) **EP 3 462 191 A1**
(43) Date de publication de la demande: **03.04.2019**
(21) Numéro de dépôt: 18197437.9
(22) Date de dépôt: 28.09.2018
(51) Int. Cl.: G01R 31/02, B60L 3/00, G01R 35/00, G01R 31/40

(54) **CIRCUIT DE DÉTECTION DE DÉFAUT DE MASSE, CHAÎNE DE TRANSFORMATION COMPRENANT UN TEL CIRCUIT, PROCÉDÉ DE DÉTECTION DE DÉFAUT DE MASSE**

(30) Priorité: 29.09.2017 FR 1759058
(71) Demandeur: ALSTOM Transport Technologies, 93400 Saint-Ouen (FR)
(72) Inventeur: BLANC, Sebastien, 65420 IBOS (FR)
(74) Mandataire: Lavoix

(57) **Abrégé**

Circuit de détection de défaut de masse (20) comprenant un bus (4) en courant continu, un capteur de courant (9) et un bloc à résistance(s) (10) comprenant au moins une résistance (15),
dans lequel le bus en courant continu comprend un premier lien (41) à une polarité d'alimentation non nulle et un deuxième lien (42) connecté à la masse par une connexion (5), ledit capteur (9) captant le courant sur ladite connexion, et une borne du bloc à résistance étant reliée à audit premier lien du bus via un interrupteur électronique (11),
ledit circuit de détection est adapté pour détecter un défaut de masse, en fonction du courant capté par le capteur de courant lorsque le bus est alimenté par un courant alternatif converti en courant continu,
ledit circuit de détection étant caractérisé en ce qu'une borne de la résistance (15) du bloc à résistance(s) est reliée à un point de connexion à la masse situé entre le capteur de courant (9) et la masse (8).

## Description

La présente invention concerne un circuit de détection de défaut de masse comprenant un bus en courant continu, un capteur de courant et un bloc à résistance(s) comprenant au moins une résistance, dans lequel le bus en courant continu comprend un premier lien à une polarité d'alimentation donnée non nulle et un deuxième lien connecté à la masse par une connexion, ledit capteur captant le courant circulant sur ladite connexion, et une borne du bloc à résistance étant reliée à audit premier lien du bus via un interrupteur électronique, dans lequel ledit circuit de détection est adapté pour détecter un défaut de masse, en fonction du courant capté par le capteur de courant lorsque le bus est alimenté par un courant alternatif converti en courant continu.

Un tel circuit est par exemple mentionné dans le document US 4 430 683.

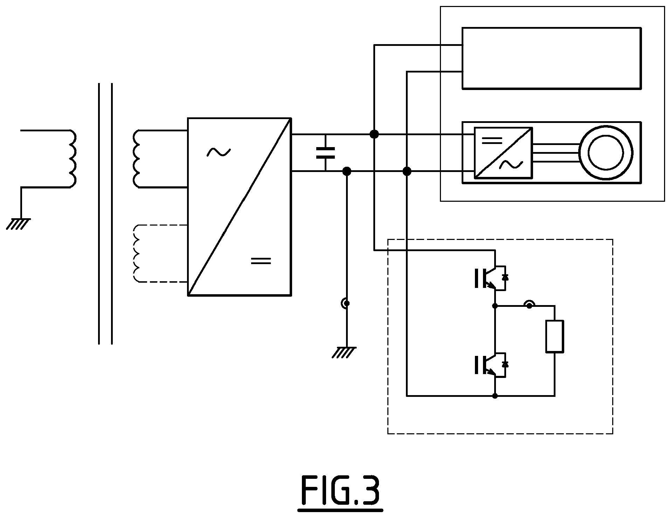

La figure 3 du présent document représente également un tel circuit dans une chaîne comportant un transformateur de tension alternative, un convertisseur de courant alternatif en continu, un ensemble (délimité par des pointillés) à interrupteurs et résistance et des charges, dont une charge comprenant un onduleur de tension et un moteur, par exemple un moteur de traction. Typiquement le circuit de détection détecte un défaut de masse au cas où un courant non nul est capté par le capteur de courant présent sur la connexion reliant la masse à un des liens du bus. Dans le cas contraire, il est considéré qu'aucun défaut à la terre n'a lieu.

Un tel circuit de détection ne permet pas de tester simplement le bon fonctionnement du capteur, puisqu'en l'absence de défaut de masse, aucun courant ne traverse le capteur : il n'est alors pas possible de distinguer si l'absence de courant mesuré est due à l'absence d'un défaut de masse ou à un dysfonctionnement du capteur ou encore à sa déconnexion. Pour tester le capteur, des pas de maintenance spécifiques doivent être implémentés, ce qui augmente le volume et le temps des opérations de maintenance.

Il existe ainsi un besoin de pouvoir tester plus complètement le bon fonctionnement du circuit de détection, sans nécessiter l'interruption de son fonctionnement opérationnel.

A cet effet, suivant un premier aspect, l'invention propose un circuit de détection de défaut de masse du type précité caractérisé en ce qu'une borne de la résistance du bloc à résistance(s) est reliée à un point de connexion à la masse situé entre le capteur de courant et la masse.

L'invention permet ainsi de tester le bon fonctionnement du circuit de détection, de façon automatique, pendant qu'il est utilisé et sans affecter son bon fonctionnement.

Dans des modes de réalisation, le circuit de détection de défaut de masse suivant l'invention comporte en outre une ou plusieurs des caractéristiques suivantes :
- le circuit de détection est adapté pour détecter un défaut de masse en fonction de la comparaison entre le courant capté par le capteur de courant et un seuil ;
- le circuit de détection de défaut de masse comprend un autre capteur de courant disposé sur la liaison reliant ladite borne de la résistance et ledit point de connexion à la masse ;
- le circuit de détection est adapté pour détecter un défaut de masse en fonction de la comparaison entre un seuil et la différence entre le courant capté par le capteur de courant et le courant capté par l'autre capteur de courant ;
- une borne de l'interrupteur est reliée au premier lien du bus et une autre borne de l'interrupteur est reliée à ladite résistance.

Suivant un deuxième aspect, la présente invention propose une chaîne de transformation comprenant un circuit de détection selon l'une des revendications précédentes, une alimentation en courant alternatif, un convertisseur de courant alternatif en courant continu disposé entre ladite alimentation et ledit circuit de détection, et un onduleur de tension couplé à un moteur de traction, le bus du circuit de détection étant disposé entre ledit inverseur de traction et ledit convertisseur.

Suivant un troisième aspect, la présente invention propose un procédé de détection de défaut de masse dans un circuit comprenant un bus en courant continu, un capteur de courant et un bloc à résistance(s) comprenant au moins une résistance, dans lequel le bus en courant continu comprend un premier lien à une polarité d'alimentation donnée non nulle et un deuxième lien connecté à la masse par une connexion, ledit capteur captant le courant circulant sur ladite connexion, et une borne du bloc à résistance est reliée à audit premier lien du bus via un interrupteur,
ledit procédé étant caractérisé en ce que, une borne de la résistance du bloc à résistance(s) étant reliée à un point de connexion à la masse situé entre le capteur de courant et la masse, le procédé comprend les étapes suivantes :
- mesure du courant capté par le capteur de courant lorsque le bus est alimenté par un courant alternatif converti en courant continu ;
- détection d'un défaut de masse en fonction de ladite mesure.

Avantageusement :
- le circuit de détection est adapté pour détecter un défaut de masse en fonction de la comparaison entre le courant capté par le capteur de courant et un seuil ;
- un autre capteur de courant est disposé sur une liaison reliant ladite borne de la résistance et ledit point de connexion à la masse et un défaut de masse est détecté en fonction de la comparaison entre un seuil et la différence entre le courant capté par le capteur de courant et le courant capté par l'autre capteur de courant ; et
- une borne de l'interrupteur est reliée au premier lien du bus et une autre borne de l'interrupteur est reliée à ladite résistance.

Ces caractéristiques et avantages de l'invention apparaîtront à la lecture de la description qui va suivre, donnée uniquement à titre d'exemple, et faite en référence aux dessins annexés, sur lesquels :
- la figure 1 représente une vue schématique d'une portion de chaîne de traction dans un mode de réalisation de l'invention ;
- la figure 2 est un organigramme d'un procédé dans un mode de réalisation de l'invention ;
- la figure 3 est une vue schématique d'un système de l'art antérieur comportant un circuit de détection de masse.

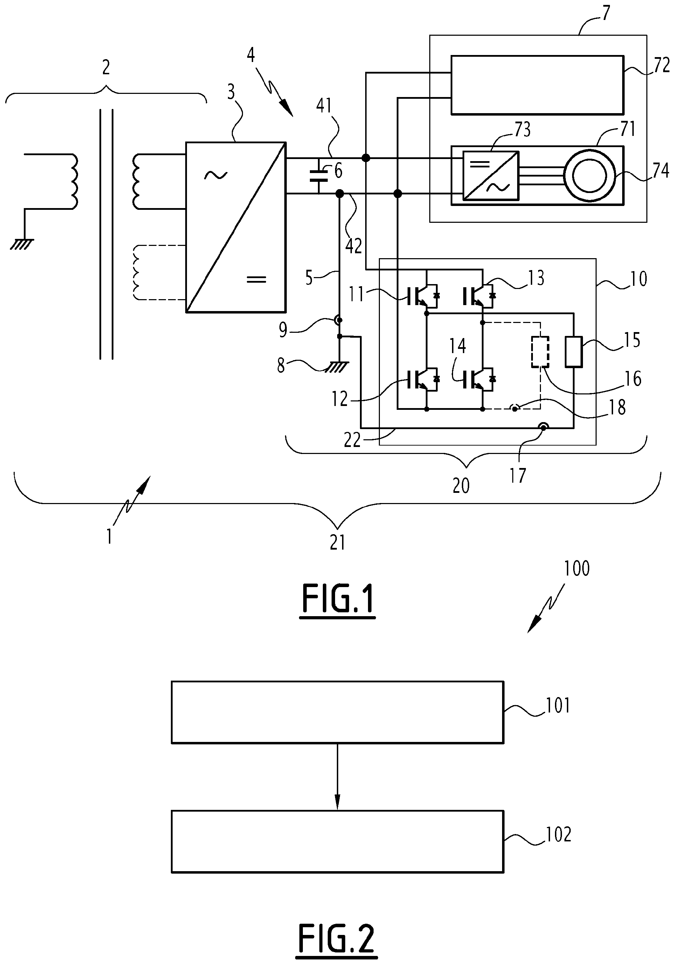

La figure 1 représente une portion 1 de chaîne de traction, par exemple mise en oeuvre dans un tramway, et qui implémente un mode de réalisation de l'invention.

Cette portion 1 de chaîne de traction d'un tramway comporte un bloc 21 de transformation d'énergie et un ensemble 7 de charges.

L'ensemble 7 de charges comprend une ou plusieurs charges : dans le cas considéré, 2 charges 71 et 72. La charge 71 comprend un onduleur 73 de tension et un moteur de traction 74, par exemple polyphasé, notamment triphasé. La charge 72 comprend par exemple un convertisseur auxiliaire.

Le bloc 21 de transformation comprend un transformateur 2, un convertisseur 3, et un circuit 20 de détection.

Le circuit 20 de détection comprend un bus continu 4, une liaison 5 de mise à la masse, un capteur de courant 9 et un ensemble à résistance(s) 10.

Le bus continu 4 comprend deux liens : le lien +HT 41 et le lien -HT 42.

Le transformateur 2 abaisse le niveau de tension de l'alimentation, en courant alternatif, qui lui est fournie en entrée et qui provient, dans le cas considéré, de la ligne aérienne d'alimentation du tramway. Le transformateur 2 comporte un circuit primaire et un ou plusieurs circuits secondaires. L'alimentation en courant alternatif ainsi transformé par le transformateur 2 est ensuite fournie en entrée du convertisseur 3, qui convertit le courant alternatif en courant continu.

La tension de sortie du convertisseur 3 est appliquée entre les liens +HT 41 et -HT 42 du bus 4. Un condensateur 6 est disposé entre les liens 41 et 42. La tension entre les liens 41 et 42 est fournie en entrée des charges respectives 71, 72.

Le lien -HT 42 est relié à une masse électrique 8 par la liaison électrique 5.

Le capteur de courant électrique 9 est disposé sur la liaison 5, il est de type à effet Hall par exemple ou d'autre type (par exemple shunt, à effet Néel etc.).

Le capteur de courant 9 mesure ainsi le courant électrique circulant sur la liaison 5.

L'ensemble à résistance(s) 10 est un circuit électrique comprenant au moins une résistance 15 et éventuellement d'autres composants suivant les cas considérés.

Dans l'exemple considéré, l'ensemble à résistance(s) 10 est un rhéostat qui comporte quatre transistors bipolaires à grille isolée, dits IGBT (de l'anglais « Insulated Gâte Bipolar Transistor ») 11, 12, 13, 14. Sa fonction est de dissiper l'énergie réinjectée par le freinage du tramway. Dans des modes de réalisation, les IGBT sont commandés de façon cyclique et se comportent ainsi de façon cyclique en interrupteurs ouverts ou fermés, et sont connectés au bus 4.

Les collecteurs des IGBT 11 et 13 sont connectés au lien +HT 41 du bus 4. Les IGBT 11 et 12 sont disposés en série, l'émetteur de l'IGBT 11 étant connecté au collecteur de l'IGBT 12. De même, les IGBT 13 et 14 sont disposés en série, l'émetteur de l'IGBT 13 étant connecté au collecteur de l'IGBT 14. Ces deux séries sont disposées en montage parallèle. Comme représentée en figure 1, une borne de l'ensemble à résistance(s) 10 connectée aux collecteurs des IGBT 11 et 13 est reliée au lien +HT 41.

Dans le mode de réalisation considéré, une borne de l'ensemble à résistance(s) 10 connectée aux émetteurs des IGBT 12 et 14 est en outre reliée au lien -HT 42.

Une borne de la résistance 15 est connectée à l'émetteur de l'IGBT 11 et l'autre borne de la résistance 15 est reliée par une liaison électrique 22 à la masse 8 directement, ou, de manière plus générale, à un point disposé entre le capteur de courant 9 et la masse 8, sur la liaison électrique 5.

Un capteur de courant 17 est disposé sur la liaison 22. Le capteur de courant 17 mesure ainsi le courant électrique circulant sur la liaison 22.

Dans des modes de réalisation, l'ensemble à résistance(s) 10 comporte une ou des résistances supplémentaires. Par exemple, comme représenté en pointillés en référence à la figure 1, une résistance 16 est en outre disposée en parallèle de l'IGBT 14 et un capteur de courant 18 est disposé sur la liaison reliant une borne de la résistance et l'émetteur de l'IGBT 14.

Dans le mode de réalisation considéré en référence aux dessins, le circuit 20 de détection comprend en outre un bloc de traitement (non représenté) comprenant des moyens de calcul. Ce bloc de traitement est adapté pour mettre en oeuvre, régulièrement, l'ensemble 100 d'étapes représenté en figure 2, pour détecter un problème de masse et un dysfonctionnement du capteur 9, dès lors que le rhéostat est piloté (i.e. qu'au moins un des interrupteurs est commandé en fermeture selon un profil de commande donné).

Dans une étape 101, le bloc de traitement recueille régulièrement les mesures de courant circulant sur la liaison 5 effectuées par le capteur de courant 9 et les mesures de courant circulant sur la liaison 22 effectuées par le capteur de courant 17. Puis, pour chaque instant de mesure successivement considéré, le bloc de traitement calcule la différence entre une mesure de courant effectuée par le capteur de courant 9 et une mesure de courant effectuée par le capteur de courant 17 correspondant au même instant de mesure. Dans une étape 102, le bloc de traitement compare à un premier seuil prédéterminé la valeur absolue de la différence calculée par instant de mesure considéré. Et le bloc de traitement détermine la présence ou l'absence d'un défaut de masse en fonction du résultat de cette comparaison. Dans le cas présent, un défaut de masse est détecté si la valeur de différence en valeur absolue est supérieure audit seuil. Par exemple, le seuil est une valeur égale à 50 ampères (A), ou plus globalement choisie dans la plage [10 A, 1000 A].

Par ailleurs, le bloc de traitement est adapté pour dans l'étape 102, détecter que le capteur de courant 9 a un dysfonctionnement, ce qui correspond à un courant nul mesuré par le capteur 9 lorsque les IGBT de l'ensemble à résistance 10 sont commandés moyennant la présence de bruit : ainsi, un défaut du capteur 9 est détecté si la valeur absolue du courant dans le capteur 9 est inférieure à un deuxième seuil prédéterminé, inférieur au premier seuil, par exemple d'une valeur égale à 20 A, ou plus globalement choisie dans la plage [10 A, 200 A].

La présente invention propose ainsi un circuit de détection permettant à la fois de détecter les problèmes de masse, tout en permettant également pendant le fonctionnement nominal du circuit, de tester le bon fonctionnement du capteur du détecteur.

L'ensemble à résistance(s) 10 considéré ci-dessus est un rhéostat d'une structure donnée, mais l'invention peut bien sûr être mise en oeuvre avec des ensembles à résistance(s) de structures différentes et variées. L'ensemble à résistance(s) 10 comprend de façon générale au moins une borne connectée au lien +HT 41 du bus 4. Il est adapté pour réguler la puissance présente sur le bus, par exemple à l'aide d'une commande fonction de la tension présente sur la ligne aérienne. Il est exemple de type hacheur, écrêteur, rhéostat. Par exemple, il est adapté pour absorber les surtensions aux bornes du bus continu 4, pour absorber la puissance de freinage générée en cas de freinage du tramway etc.

Par ailleurs, l'invention peut également être mise en oeuvre sans qu'aucun capteur de courant ne soit disposé sur le lien connectant une résistance de l'ensemble à résistance(s) 10 à un point situé, sur la liaison 5, entre la masse 8 et le capteur de courant 9. Dans un tel cas, le bloc de traitement recueille régulièrement les mesures de courant circulant sur la liaison 5 effectuées par le capteur de courant 9. Là encore, il compare la valeur absolue de chaque mesure de courant (ou une valeur représentative desdites mesures de courant, par exemple une moyenne d'un certain nombre des dernières mesures etc.) à un troisième seuil prédéterminé. Et il détermine la présence ou l'absence d'un défaut de masse en fonction du résultat de cette comparaison lorsqu'aucun interrupteur de l'ensemble à résistance 10 n'est commandé à la fermeture. Dans le cas présent, un défaut de masse est détecté si la valeur de courant en valeur absolue est supérieure audit troisième seuil. Par exemple, le troisième seuil auquel est comparé le courant mesuré est une valeur égale à 50 A, ou plus globalement choisie dans la plage [10 A, 1000 A].

Par ailleurs, le bloc de traitement est adapté pour détecter que le capteur de courant 9 a un dysfonctionnement, ce qui correspond à un courant mesuré par le capteur 9 nul lorsque les IGBT de l'ensemble à résistance 10 sont commandés moyennant la présence de bruit : ainsi, un défaut du capteur 9 est détecté si la valeur absolue du courant dans le capteur 9 est inférieure à un quatrième seuil prédéterminé, inférieur au troisième seuil , par exemple de valeur égale à 20 A, ou plus globalement choisie dans la plage [10 A,200 A].

L'invention a été décrite ci-dessus dans le cas d'un système de traction, mais peut bien évidemment être utilisée dans d'autres domaines.

## Revendications

1. Circuit de détection de défaut de masse (20) comprenant un bus (4) en courant continu, un capteur de courant (9) et un bloc à résistance(s) (10) comprenant au moins une résistance (15),
dans lequel le bus en courant continu comprend un premier lien (41) à une polarité d'alimentation donnée non nulle et un deuxième lien (42) connecté à une masse électrique par une connexion (5), ledit capteur (9) captant le courant circulant sur ladite connexion, et une borne du bloc à résistance étant reliée audit premier lien du bus via un interrupteur électronique (11),
dans lequel ledit circuit de détection est adapté pour détecter un défaut de masse, en fonction du courant capté par le capteur de courant lorsque le bus est alimenté par un courant alternatif converti en courant continu,
ledit circuit de détection étant **caractérisé en ce qu'**une borne de la résistance (15) du bloc à résistance(s) est reliée à un point de connexion à la masse situé entre le capteur de courant (9) et la masse électrique (8).

2. Circuit de détection de défaut de masse (20) selon la revendication 1, dans lequel le circuit de détection est adapté pour détecter un défaut de masse en fonction de la comparaison entre le courant capté par le capteur de courant et un seuil.

3. Circuit de détection de défaut de masse (20) selon la revendication 1 ou 2, comprenant un autre capteur de courant (17) disposé sur une liaison (22) reliant ladite borne de la résistance et ledit point de connexion à la masse.

4. Circuit de détection de défaut de masse (20) selon la revendication 3, dans lequel le circuit de détection est adapté pour détecter un défaut de masse en fonction de la comparaison entre un seuil et la différence entre le courant capté par le capteur de courant et le courant capté par l'autre capteur de courant.

5. Circuit de détection de défaut de masse (20) selon l'une quelconque des revendications précédentes, dans lequel une borne de l'interrupteur est reliée au premier lien du bus et une autre borne de l'interrupteur est reliée à ladite résistance.

6. Chaîne de transformation (21) comprenant un circuit de détection (20) selon l'une des revendications précédentes, une alimentation (2) en courant alternatif, un convertisseur (3) de courant alternatif en courant continu disposé entre ladite alimentation et ledit circuit de détection, et un onduleur de tension (73) couplé à un moteur de traction (74), le bus en courant continu (4) du circuit de détection étant disposé entre ledit onduleur de tension (73) et ledit convertisseur.

7. Procédé de détection de défaut de masse dans un circuit (20) comprenant un bus (4) en courant continu, un capteur de courant (9) et un bloc à résistance(s) (10) comprenant au moins une résistance (15), dans lequel le bus en courant continu comprend un premier lien (41) à une polarité d'alimentation donnée non nulle et un deuxième lien (42) connecté à une masse électrique par une connexion (5), ledit capteur captant le courant circulant sur ladite connexion, et une borne du bloc à résistance est reliée audit premier lien du bus via un interrupteur électronique (11),
ledit procédé étant **caractérisé en ce que**, une borne de la résistance du bloc à résistance(s) est reliée à un point de connexion à la masse situé entre le capteur de courant (9) et la masse électrique (8), le procédé comprenant les étapes suivantes :
- mesure du courant capté par le capteur de courant lorsque le bus est alimenté par un courant alternatif converti en courant continu ;
- détection d'un défaut de masse en fonction de ladite mesure.

8. Procédé de détection de défaut de masse (20) selon la revendication 7, selon lequel le circuit de détection est adapté pour détecter un défaut de masse en fonction de la comparaison entre le courant capté par le capteur de courant et un seuil.

9. Procédé de détection de défaut de masse (20) selon la revendication 7 ou 8, selon lequel un autre capteur de courant (17) est disposé sur une liaison (22) reliant ladite borne de la résistance et ledit point de connexion à la masse et un défaut de masse est détecté en fonction de la comparaison entre un seuil et la différence entre le courant capté par le capteur de courant et le courant capté par l'autre capteur de courant.

10. Procédé de détection de défaut de masse (20) selon l'une quelconque des revendications 7 à 9, selon lequel une borne de l'interrupteur est reliée au premier lien du bus et une autre borne de l'interrupteur est reliée à ladite résistance.
